(19) **Europäisches Patentamt / European Patent Office / Office européen des brevets**

(11) **EP 2 730 032 B1**

(12) **EUROPEAN PATENT SPECIFICATION**

(45) Date of publication and mention of the grant of the patent:
**14.04.2021 Bulletin 2021/15**

(21) Application number: **12806913.5**

(22) Date of filing: **05.07.2012**

(51) Int Cl.:
*H01Q 5/25* (2015.01)    *H04B 1/18* (2006.01)
*H03H 11/44* (2006.01)    *H01Q 23/00* (2006.01)
*H03H 7/40* (2006.01)    *H03H 11/30* (2006.01)

(86) International application number:
**PCT/US2012/045632**

(87) International publication number:
**WO 2013/006740 (10.01.2013 Gazette 2013/02)**

(54) **AUTOMATIC TUNING CIRCUIT**

AUTOMATISCHE ABSTIMMSCHALTUNG

CIRCUIT D'ACCORD AUTOMATIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.07.2011 US 201161505079 P**
            **06.07.2011 US 201113177479**
            **06.07.2011 US 201161505037 P**
            **15.05.2012 US 201213472396**

(43) Date of publication of application:
**14.05.2014 Bulletin 2014/20**

(73) Proprietor: **HRL Laboratories, LLC**
**Malibu, CA 90265-4799 (US)**

(72) Inventors:
• **HITKO, Donald A.**
  **Grover Beach, California 93433 (US)**
• **WHITE, Carson R.**
  **Agoura Hills, California 91301 (US)**
• **COLBURN, Joseph S.**
  **Malibu, California 90265 (US)**
• **YUNG, Michael W.**
  **Los Angeles, California 90064 (US)**

(74) Representative: **Richards, John et al**
**Ladas & Parry LLP**
**Temple Chambers**
**3-7 Temple Avenue**
**London EC4Y 0DA (GB)**

(56) References cited:
**EP-A1- 2 290 745**      **JP-A- 2008 278 159**
**US-A1- 2008 164 955**    **US-A1- 2008 242 237**
**US-B1- 6 538 621**      **US-B1- 6 952 565**

• **MIRZAEI H ET AL: "A wideband metamaterial-inspired compact antenna using embedded non-Foster matching", ANTENNAS AND PROPAGATION (APSURSI), 2011 IEEE INTERNATIONAL SYMPOSIUM ON, IEEE, 3 July 2011 (2011-07-03), pages 1950-1953, XP032191593, DOI: 10.1109/APS.2011.5996885 ISBN: 978-1-4244-9562-7**
• **SUSSMAN-FORT S E ET AL: "Non-Foster Impedance Matching of Electrically-Small Antennas", IEEE TRANSACTIONS ON ANTENNAS AND PROPAGATION, IEEE SERVICE CENTER, PISCATAWAY, NJ, US, vol. 57, no. 8, 1 August 2009 (2009-08-01) , pages 2230-2241, XP011269388, ISSN: 0018-926X, DOI: 10.1109/TAP.2009.2024494**
• **SUSSMAN-FORT, S.E. ET AL.: 'NON-FOSTER IMPEDANCE MATCHING OF ELECTRICALLY-SMALL ANTENNAS' IEEE TRANSACTIONS ON VOLUMN 58 vol. 57, no. 8, August 2009, pages 2230 - 2241, XP011269388 Retrieved from the Internet: <URL:http://ieeexplore.ieee.org/stamp/stamp .js p?tp=&arnumber=5067360>**

## Description

## Technical Field

This present technology relates to a wide bandwidth automatic tuning circuit. Automatic tuning circuits are used to connect a transmitter and/or a receiver to an antenna with a better impedance match than if the transmitter and/or the receiver were directly connected to the antenna.

## Background

The useable radio spectrum is limited and traditionally the available spectrum has been licensed to particular users or groups of users by governmental agencies, such as the Federal Communications Commission in the United States. This licensing paradigm may be on the cusp of change. In the article "The End of Spectrum Scarcity" published by IEEE Spectrum, the authors note that while some available spectrum is congested, much of it is underutilized. They predict a future where spectrum is cooperatively shared and where smart antennas will adaptively lock onto a directional signal and when used in a transmission mode, operate directionally as opposed to omnidirectionally.

In terms of sharing spectrum, one way of doing so is by the use of spread spectrum technologies. Ultra-wideband (UWB) technology uses ultra wide bandwidths (for example, in excess of 500 MHz) to transmit information which in theory at least should not interfere with existing narrow band licensees (whose narrow band transmissions have bandwidths in the 0.5 to 15KHz range).

Another spectrum sharing technique which is currently under discussion is cognitive radio which envisions using underutilized portions of the radio spectrum on an as needed basis. Cognitive radio can adapt to using different parts or portions of the radio spectrum when those parts or portions are not being actively used by another user.

Both UWB and cognitive radio have a need for widebanded communication equipment, with bandwidths significantly wider than found in most conventional radio equipment today. It is believed that future radio equipment will operate over much wider bandwidths than typical radio equipment does today.

It is well known that the performance of electrically-small antennas (ESAs) is limited when using traditional (i.e. passive) matching networks. Specifically, ESAs have high quality factor, leading to a tradeoff between bandwidth and efficiency. The most common definition of a ESA is an antenna whose maximum dimension (of an active element) is no more than $1/2\pi$ of a wavelength of the frequencies at which the antenna is expected to operate. So, for a dipole with a length of $\lambda/2\pi$, a loop with a diameter of $\lambda/2\pi$, or a patch with a diagonal dimension of $\lambda/2\pi$ would be considered electrically small.

ESAs are very popular. They allow the antennas to be small. But due to their smallness, they can be very narrow banded.

The conventional way of dealing with an antenna which is used with a receiver and/or a transmitter with operates over a frequency band, and particularly where the antenna is mis-sized (electrically small) compared the frequency to be utilized, is to use an antenna matching network. Antenna matching networks operate ideally only at some particular frequency and therefore if the transmitter or receiver changes frequency, the mating network should normally be retuned to try to obtain an ideal match between the transmitter or receiver.

A passive adaptive antenna match is taught by US patent 4,234,960. The antenna in US patent 4,234,960 is resonated by a passive tuning circuit that is adjusted using a motor. A phase detector senses the presence of reactance and drives the motor until the reactance has been eliminated. This has two disadvantages: 1) the bandwidth is narrow due to the use of a passive tuning circuit, which necessitates the use of coarse (frequency sensing) and fine adjust, and 2) the motor driven tuning is slower than electronic tuning.

A "RF-MEMS based adaptive antenna matching module" taught by A. V. Bezooijen, et al., 2007 IEEE RFIC Symposium, resonates the antenna with a MEMS switched capacitor array. A phase detector senses the phase of the input impedance and steps the capacitance of the matching circuit either up or down by 1 increment depending on the sign of the phase. Disadvantages: 1) a positive capacitance does not resonate a monopole-type ESA 2) passive matching circuit results in narrow-band solution for ESA; and 3) digital tuning gives limited number of states.

Non-Foster matching networks overcome the limitations of passive circuits by using active circuits to synthesize negative capacitors and negative inductors in the antenna matching networks. When placed correctly, these circuits can directly subtract the from the antenna's reactance. For example, a 6" monopole antenna has a reactance that may be approximated by a 3 pF capacitor at frequencies well below resonance. When combined with a -3.1 pF non-Foster capacitor, the net reactance is given by a 93 pF capacitor (using Eqn. (3) below), which is a 30 times improvement since the reactance is reduced by 30 times An example of a small electric antenna with an impedance matching network comprising a tunable non-Foster element is taught by EP 2 290 745 A1.

There are two related problems with this approach that need to be addresses before non-Foster matching is robust enough to be deployed in products: stability and accuracy. Negative capacitance is achieved using feedback circuits whose stability depends on both the internal circuit parameters and the load impedance; instability leads to either oscillation (i.e. emission of a periodic waveform from the circuit) or latchup. Unfortunately, the optimal impedance match typically occurs near the point where the stability margin goes to zero. Since non-Foster matching involves the subtraction of large reactances, high accuracy (tolerance ~ 1/Q) is needed to ensure both stability and optimal antenna efficiency. Consider the example just given, where the 6" monopole antenna, which has a reactance that may be approximated by a 3 pF capacitor at frequencies well below resonance, is combined with a -3.1 pF non-Foster capacitor. The match is theoretically better with a -3.05 pF non-Foster capacitor, but if the net capacitance goes negative (see Eqn. (3)), then the match is unstable. There will probably always be manufacturing tolerances in making both antennas and circuits or devices, but as accuracy improves, the better the match network can be designed using a non-Foster negative impedance capacitor whose absolute value is even closer to the capacitance of the antenna. But accuracy and stability are related since the accuracy (or lack thereof) by which components can be manufactured will impact the likelihood of an unstable situation arising by reason of the combined antenna impedance and match network impedance being negative.

Component and manufacturing tolerances, as well as temperature and environmental loading effects, suggest that even a 10% error may be challenging to achieve using prior art non-Foster circuits.

Having a robust non-Foster automatic tuning circuit for coupling a transmitter and/or a receiver to an antenna, especially a ESA, would be useful for use in automobiles since it would allow the antenna design to be further reduced in size which is turn can lead to more aesthetic automobile designs and in vehicles generally (including automobiles, trucks, trains, planes, ship and boats) where a smaller antenna is likely to reduce drag and thereby increase efficiency. There are many more applications for this technology, such as the cognitive and UWB radios mentioned above.

## Brief description

In one aspect the present technology provides an automatic tuning circuit for matching an antenna to a radio receiver according to claims 1 or 2.

In another aspect, the present technology provides a method of matching an antenna to a radio receiver according to claims 6 or 7.

## Brief Description of the Drawings

Fig. 1 is a schematic block diagram of an auto-tuning non-Foster matching circuit.

Fig. 2 is a schematic diagram of an exemplary tunable non-Foster negative capacitor. The negative impedance converter transforms the model capacitor, Cm, to a negative capacitance, -Cm. The variable capacitance, Cvar, provides tunability.

Fig. 3 depicts a simulation setup for a SPICE simulation. The circuits of Figs. 1 and 2 have been simulated using an ideal non-Foster negative capacitor and an ideal double balanced mixer.

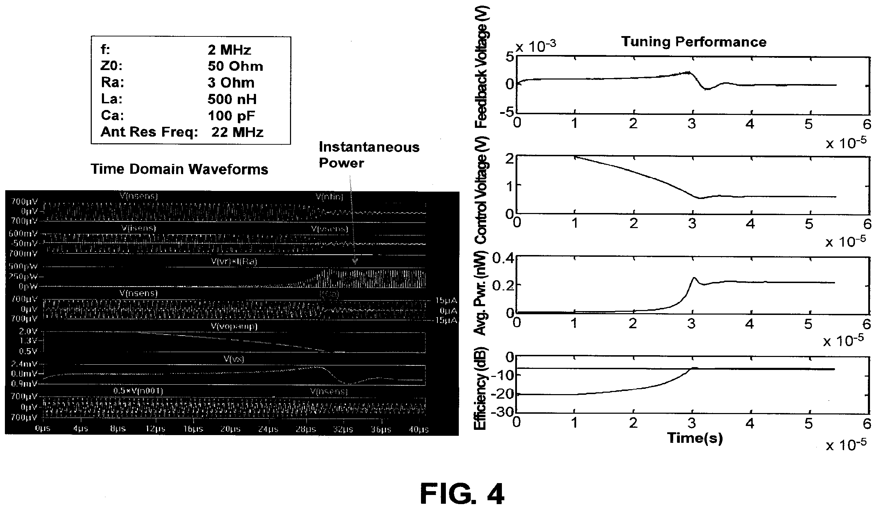

Fig. 4 depicts the time domain results of the SPICE simulation of Fig. 3. The circuit converges to optimal efficiency in 35 microseconds. The efficiency improvement is more than 10 dB.

Fig. 5 depicts a schematic diagram of a prototype variable non-Foster circuit.

## Detailed Description

This technology provides an automatically-tuning non-Foster matching circuit, which automatically drives the input reactance ($X_{in}$) to zero at one frequency where $X_{in}$ is the imaginary part of the input impedance ($Z_{in}$), so $Z_{in} = R_{in} + jX_{in}$. It is well known that the performance of electrically-small antennas (ESAs) is limited when using traditional (i.e. passive) matching networks due to their high antenna Q. Non-Foster Circuits (NFCs) can reduce the antenna reactance by orders of magnitude by synthesizing negative capacitance or negative inductance, which are then placed in series (for example, when using negative capacitance to match monopole or dipole antennas) or parallel (for example, when using negative inductance to match slot or loop antennas) such that they cancel the antenna reactance over a broad bandwidth. A high degree of accuracy is desired to effectively cancel large antenna reactances. In addition, NFCs are conditionally stable, and typically have a very small stability margin at the point where they best cancel the antenna reactance. Therefore it is important to design and control the NFC circuit very accurately in order to optimize performance while keeping the circuit stable.

Considering a series R-L-C circuit, the input impedance is given by Eqn (1) below:

$$Z_{in} = R + sL + 1/sC$$ Eqn. (1)

where R is the resistance, L is the inductance, C is the capacitance, s=j $\omega$, $\omega$ is the radian frequency, and j=sqrt(-1). When terminated by a receiver impedance $R_0$, a loop is created with impedance $Z_{loop} = Z_{in} + R_0 = R' + sL + 1/sC$. It has been shown in the literature that the system is unstable if $Z_{loop}$ has zeros in the Right Half Plane (RHP); $Z_{loop}$ has zeros given by Eqn. (2) below:

$$S_z = 0.5 \left( -\frac{R'}{L} \pm \sqrt{\left(\frac{R'}{L}\right)^2 - \frac{4}{LC}} \right)$$ Eqn. (2)

It can be seen that when R' and L are > 0, there is a RHP solution for $s_z$ if and only if $C < 0$. Therefore, the net capacitance must be positive for stability. In addition, the circuit resonates when at the frequency given by $f_o = 1/2\pi\sqrt{LC}$ when $C$ is positive. With non-Foster matching, the negative capacitance produced by the NFC, $-C_{NF}$, is connected in series with the positive capacitance of the antenna, $C_a$, producing a net capacitance given by Eqn. (3) below:

$$C = \frac{-C_a C_{NF}}{C_a - C_{NF}}$$ Eqn. (3)

Therefore the circuit may be tuned to resonate *at $f_o$* while remaining stable by starting with $-C_{NF}$ comfortably below $-C_a$ and tuning $-C_{NF}$ to approach $-C_a$. In theory, $-C_{NF}$ can equal $-C_a$ (so that perfect cancellation occurs), but if the combination of the two capacitances is a negative value, the condition is unstable. So in practice $-C_{NF}$ is preferably tuned to only to approach $-C_a$ with the difference being set by the gain of the feedback loop.

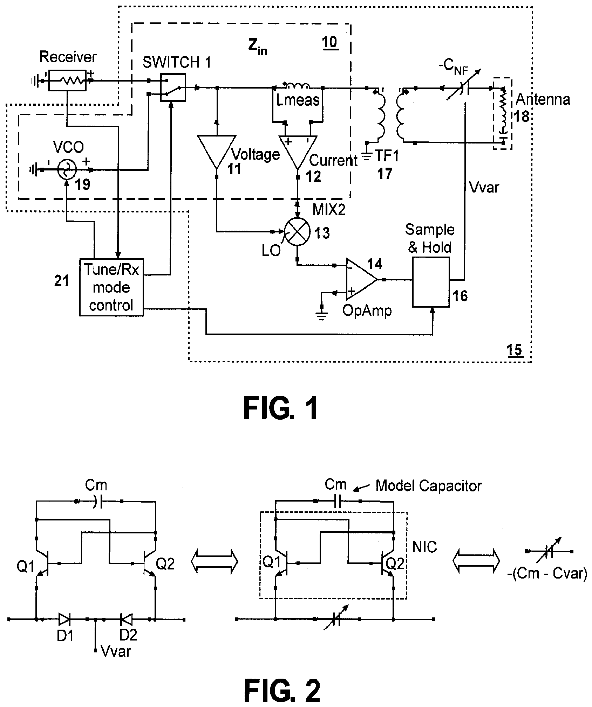

The circuit of Fig. 1 includes a tunable negative (i.e. non-Foster) capacitor $C_{NF}$, sensing circuitry 10 for sensing the reactance in real-time, and an associated feedback loop 15 that automatically drives the input reactance $X_{in}$ to zero. In this embodiment, the sensing circuitry is also considered part of the feedback loop. The antenna is assumed to be a monopole whose length is typically much less than a quarter wavelength to enable the antenna is fit inside an appliance with houses the associated receiver and transmitter (a transceiver), such as, for example, a cellphone (and particularly a transceiver which needs to operate over a range of different frequency bands such as a multi-band cellphone, for example). Any sort of antenna with a series-type first resonance may be used in lieu of a monopole, such as a dipole antenna, a patch antenna, a F antenna, etc. In addition, inductive antennas with parallel-type resonances (e.g. slot and loop antennas) may be used when the negative (i.e. non-Foster) capacitor $C_{NF}$ is replaced by a variable negative inductance. In this alternative embodiment, the negative inductance is placed in series with the antenna. This alternative embodiment is less desirable than the embodiment using the negative (i.e. non-Foster) capacitor $C_{NF}$.

The present technology is primarily applicable to antennas with series type first resonances because the combined reactance of the antenna, the NFC, and $L_{meas}$ must have only one zero crossing as the reactance of the NFC is varied. This is not true for a parallel type resonance with a shunt tuning element because Lmeas is in series with the shunt elements. Therefore, the reactance has either zero or two zero crossings. Monopoles and dipoles are capacitive and have series type first resonance; slots and loops are inductive and have parallel type first resonance. The present technology is also applicable to parallel resonant antennas with series negative inductors, as mentioned in the preceding paragraph.

The sensing circuit 10 includes a variable frequency oscillator 19 (which may be implemented by a voltage controlled oscillator or VCO) which injects a signal at the desired frequency of operation via a switch (SWITCH 1); this signal may be either a transmit signal for transmitter or transceiver applications or a low output power oscillator that is switched onto the signal path (via SWITCH 1) in order to measure the reactance at $Z_{in}$ for receive applications. If the circuit of Fig. 1 is to be used in a receiver application only, then the low output power oscillator 19 can preferably be designed to generate such low power that the receiver does not need to be licensed as a transmitter by governmental licensing authorities such as the FCC in the United States (a small amount of power is sent to the antenna). If the circuit of Fig. 1 is to be used in a transceiver application, then the transmitter portion of the transceiver can be conveniently used as the variable frequency oscillator 19.

The input voltage is directly sensed using a single-ended buffer 11 (which may be implemented as an Operational Amplifier (OpAmp)), and the input current is sensed by connecting a differential buffer 12 (which may be implemented as an OpAmp) across a small inductor, $L_{meas}$, that is inserted specifically for the reactance measurement. The small inductor may only impose one or two ohms of reactance and its value is a matter of design choice depending on the sensitivity desired. The voltage across $L_{meas}$ is proportional to the input current, but shifted by 90°. Therefore, multiplying the voltage and current signals using a double balanced mixer 13 (keeping only the DC output, using a low-pass filter if need be), directly results in a reactance measurement. The double balanced mixer is considered part of the feedback circuit in this detailed description, but it can also be considered part of the sensing circuit 10 as well.

A double balanced mixer 13 should be utilized in order to preserve the sign of the reactance. This voltage is then applied to an OpAmp 14, which produces the tuning voltage for the tunable negative capacitor such that the input reactance ($X_{in}$) is driven to zero.

This circuit may be used in two modes: continuous tuning and periodic tuning. Continuous tuning is useful for transmit antenna matching. In this mode, where the signal is constantly applied at a center frequency $f_0$, the feedback loop is always on and no sample and hold circuit 16 is needed and no mode control switch or circuit 21 is needed. The periodic mode is useful for receive antenna matching. In the periodic mode, the circuit is switched at SWITCH 1 (in response to the state of mode control switch or circuit 21) between the receiver and the oscillator 19. The mode control switch or circuit 21 has two states: a tuning state and a receive state. When the mode control switch or circuit 21 is in its tuning state, the oscillator 19 applies a signal in the sensing circuit 10 and the feedback circuit 15 drives the reactance to zero while the sample and hold circuit 16 samples the tuning voltage. When the mode control switch or circuit 21 is in its receive state, the circuit is switched at SWITCH1 to the receiver but the just determined tuning voltage is held constant by the sample and hold circuit 16. In the preferred embodiment, the circuit starts up with $-C_{NF}$ comfortably below $-C_a$, and may be reset to that level at the beginning of each tuning state. The circuit may be switched into its tuning mode at an interval fast enough to adapt to environmental changes due to temperature or a dynamic environment and may be in the tuning (i.e. transmit) mode just long enough to tune the antenna so that interruptions to reception are minimized. In one example, the circuit may be switched into the tuning mode for 50 microseconds every 50 milliseconds.

The sample and hold circuit 16 maintains the tuning voltage on the NFC while the receiver is in its receive state. Reasons for doing this periodically are:

(1) The characteristics of the antenna will change. The classic example is a cell phone which will have a different impedance when it is in the user's hand than it will on the table, which could lead to oscillation. Temperature effects can additionally affect the characteristic of a cellphone. These changes are the prime motivation for this invention.
(2) It may be beneficial to tune to different frequencies for different operating modes (e.g. 1.8 GHz one moment, then FM or TV broadcast frequencies at another moment).

The transformer 17 preferably couples the sensing circuit to the antenna 18 and the NFC (implemented as the negative capacitor $-C_{NF}$ in this embodiment). Depending on the configuration of the antenna match, the NFC could instead be implemented as a negative inductor. Many antenna match circuits are known in the art which utilize variable capacitors and/or inductors, and selecting one of the variable capacitors or inductors in such circuits to be implemented as a negative reactive element (i.e. negative capacitor or negative inductor) can have a profound impact on the bandwidth of the antenna match circuit.

The antenna 18 may be any sort of antenna, but if a ESA is utilized, then it is preferably either a dipole or a monopole antenna as those antenna types are frequently used ESAs.

An exemplary tunable NFC is shown in Fig. 2 as three different representations of the same circuit. On the left hand side is a circuit with two varactor diodes which is electrically equivalent to the center presentation which shows a variable capacitor in place of the two varactor diodes. On the right hand side is the result (- (Cm - Cvar)). This circuit is based on Linvill's floating Negative Impedance Converter (NIC), but is an improvement there over and results in a tunable negative capacitance. A positive capacitance Cm is connected between the collectors of bipolar transistors Q1 and Q2. The input impedance looking into the emitters is given by $-1/j\omega Cm$; therefore, the combination of Cm and the NIC is equivalent to a capacitor with value -Cm. A variable capacitor (in the center representation) with capacitance Cvar is connected between the emitters of Q1 and Q2; this combines with -Cm to give a tunable capacitance given by - (Cm - Cvar) between the two emitters. In embodiment on the left hand side, the variable capacitor is implemented by back-to-back reverse-biased varactor diodes D1 and D2, where the bias voltage from the sample and hold circuit 16 is applied to the Vvar node relative to the emitter voltage.

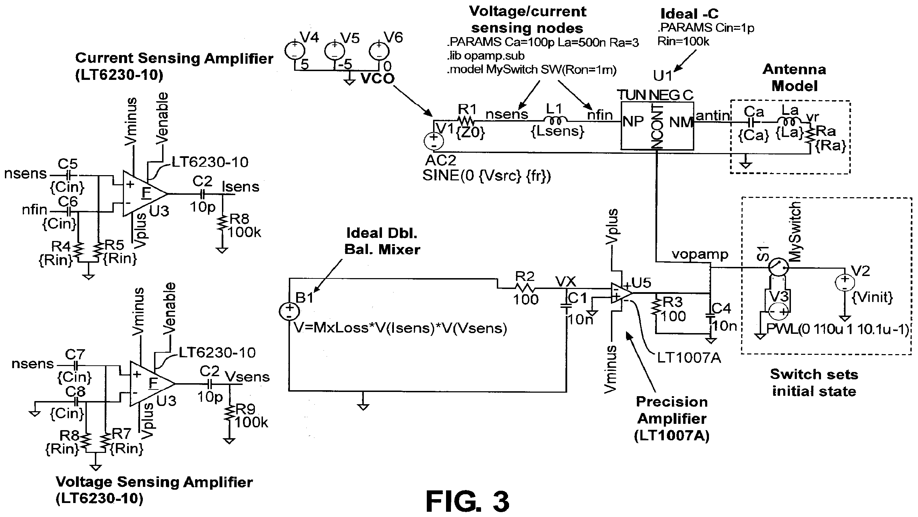

A SPICE simulation has been performed of the circuits of Figs 1 and 2, and the setup therefor is shown in Fig. 3. The antenna 18 is modeled as a series R-L-C circuit with values, and is tuned with an ideal voltage-controlled negative capacitor 19 whose capacitance in pF is given by -C = -80 - 35*Vc, where Vc is the control voltage (equal to Vvar in Fig. 2). Voltage source V2 and switch S1 set the initial bias state (-C = -150 pF), and the feedback loop is closed at 10 microseconds. The voltage and current sensing buffers are implemented with high-speed operational amplifiers, and the double-balanced mixer is implemented with a behavioral model assuming ideal multiplication and 6 dB insertion loss. The final element of the feedback loop is a precision operational amplifier to drive the reactance to zero. The simulation demonstrates convergence to the optimum efficiency (-6.7 dB) in 25 microseconds. The final non-Foster capacitance value is -C = -101 pF, which increases the total capacitance from 100 pF to 8.9 nF and resonates the antenna at 2 MHz.

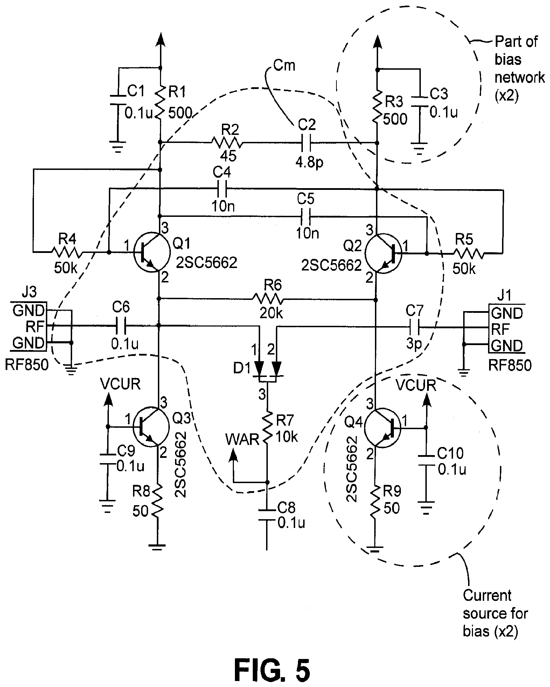

The circuits of Figs. 2 and 5 have been built and tested. The test results are discussed in Appendix A to this application entitled "A Non-Foster-Enhanced Monopole Antenna". In that embodiment, after testing, Cm was selected to be a 5.6 pF capacitor while Cvar should preferably have a tuning range of about 4-10 pF in that embodiment, so the diodes D1 and D2, being in series, should then having a tuning range of about 2-5 pF in that embodiment.

The circuits of Fig. 2 show one possible embodiment of a NFC to implement the negative capacitor $-C_{NF}$. Other NFC are depicted in the US Provisional Patent Application identified above which is incorporated herein by reference. In particular, the tunable NFC shown in Fig. 1(c) thereof could be used in place of the circuits of Fig. 2. Since the tunable NFC shown in Fig. 1(c) thereof is tunable as described therein, the addition of capacitor Cvar is not required at the negative impedance output thereof, but nevertheless the capacitor Cvar (preferably implemented as diodes D1 and D2) may be added negative impedance output thereof similarly to the modification to Linvill's circuit proposed by Fig. 2 hereof.

As is also mentioned in Appendix A, adding some resistance in series with Cm results in negative resistance at the output of the NFC which in turn adds gain.

The circuits of Fig. 2 will produce a negative capacitance even if Cm is omitted due to the parasitic capacitance associated with transistors Q1 and Q2. We find it preferable to include a capacitor Cm since varactor diodes D1 and D2 contribute a positive capacitance which is somewhat smaller than the value of Cm, to obtain, as a result, a rather small negative capacitance which is exactly what is needed to provide a match with electrically small antennas. If Cm is omitted, the circuit theoretically works just fine, but there are practical problems in finding varactor diodes D1 and D2 which would contribute a positive capacitance which is somewhat smaller than the value contributed by the parasitic capacitance associated with transistors Q1 and Q2.

Fig. 5 depicts a schematic diagram of a preferred embodiment of a negative capacitance circuit 30, where variable negative capacitance appears between terminals 31 and 32. It should be readily apparent that the core 33 of the circuit 30 is nearly identical to the embodiment described with reference to Fig. 2 and includes transistors Q1 and Q2, capacitance Cm and a pair of reverse-biased varactor diodes which accept the tuning voltage Vvar. In addition, resistors R2 and R6 compensate for parasitic resistances of the circuit; resistor R7 presents a high impedance to the RF signal; DC blocking capacitors C4 and C5 allow a difference in potential between the collectors and bases of Q1 and Q2, and capacitor C6 AC couples the core of the circuit to pin 31. In a preferred embodiment, pin 32 may be connected to an antenna while pin 31 may be connected a transformer 17 or a reactance-sensing circuit 10. Current sources 34 and 35 accept control voltage Vcur and force a current to flow through transistors Q1 and Q2 (preferably 10 mA each) and resistors R1 and R2 are connected between the collectors of Q1 and Q2, respectively, and the supply voltage 36 (preferably 20V). Resistors R4 and R5 complete the bias network, creating a difference in potential between the collectors and bases of Q1 and Q2, respectively.

It will be apparent to a skilled practitioner that while NPN transistors are shown in Fig. 5, PNP transistors may be substituted by inverting the supply voltages. Furthermore, field-effect transistors (FETs) or other transistor-like devices may be used in place of bipolar transistors with minor modifications to the bias network.

Having described the invention in connection with certain embodiments thereof, modification will now suggest itself to those skilled in the art. As such, the invention is not to be limited to the disclosed embodiments except as is specifically required by the appended claims.

**Claims**

1. An automatic tuning circuit for matching an antenna (18) to a radio receiver, the automatic tuning circuit comprising:

   a tunable non-Foster circuit (-CNF) adapted for coupling the receiver and the antenna; and
   sensing (10) and feedback (15) circuits adapted for sensing the combined reactance of the tunable non-Foster circuit (-CNF) and the antenna (18) and adapted for tuning the tunable non-Foster circuit (-CNF) to automatically minimize the combined reactance of the tunable non-Foster circuit (-CNF) and the antenna (18);
   **characterized in that**
   the tunable non-Foster circuit (-CNF) comprises an otherwise non-tunable non-Foster circuit (Cm, Q1, Q2) with a variable capacitance (Cvar) added across a negative impedance (-Cm) output of the otherwise non-tunable non-Foster circuit (Cm, Q1, Q2) to thereby render the otherwise non-tunable non-Foster circuit tunable;
   wherein the variable capacitance (-Cm) is supplied by reverse biased varactor diodes (D1, D2) coupled in parallel with the negative impedance output of the otherwise non-tunable non-Foster circuit (Cm, Q1, Q2), a junction point between the series coupled varactor diodes providing a control input to the tunable non-Foster circuit.

2. An automatic tuning circuit for matching an antenna (18) to a radio receiver, the automatic tuning circuit comprising:

a tunable non-Foster circuit (-CNF) adapted for coupling the receiver and the antenna; and
sensing (10) and feedback (15) circuits adapted for sensing the combined reactance of the tunable non-Foster circuit (-CNF) and the antenna (18) and adapted for tuning the tunable non-Foster circuit (-CNF) to automatically minimize the combined reactance of the tunable non-Foster circuit (-CNF) and the antenna (18);
a variable frequency oscillator (19), and means (SWITCH1) for coupling the variable frequency oscillator (19) and the antenna (18) using said tunable non-Foster circuit (-CNF);
**characterized in that**
the tunable non-Foster circuit (-CNF) comprises an otherwise non-tunable non-Foster circuit (Cm, Q1, Q2) with a variable reactance (Cvar) added across a negative impedance (-Cm) output of the otherwise non-tunable non-Foster circuit (Cm, Q1, Q2) to thereby render the otherwise non-tunable non-Foster circuit tunable; and wherein the variable reactance (Cvar) is supplied by reverse biased varactor diodes (D1, D2) coupled in parallel with the negative impedance (-Cm) output of the otherwise non-tunable non-Foster circuit (Cm, Q1, Q2), a junction point between the series coupled varactor diodes (D1, D2) providing a control input to the tunable non-Foster circuit.

3. The automatic tuning circuit of claim 1, or 2 wherein the sensing (10) and feedback (15) circuits comprise:

means for sensing (10) an input impedance associated with the antenna (18) and the tunable non-Foster circuit (-CNF) when a RF signal is applied to the antenna (18) and the tunable non-Foster circuit (-CNF) via the means for sensing (10); and
an operational amplifier (14) whose output is coupled to the control input of the tunable non-Foster circuit (-CNF).

4. The automatic tuning circuit of claim 3 wherein the sensing (10) and feedback (15) circuits further comprise a sample and hold circuit (16) coupled between said operational amplifier (14) and said control input of the tunable non-Foster circuit (-CNF).

5. The automatic tuning circuit of claim 1 or 2 wherein the tunable non-Foster circuit (-CNF) emulates a variable negative capacitor and wherein the antenna (18) is a dipole or a monopole.

6. A method of matching an antenna (18) to a radio receiver, the method comprising:

coupling a tunable non-Foster circuit (-CNF) between the receiver and the antenna (18), the receiver and the antenna (18) having a combined reactance;
sensing the combined reactance of the tunable non-Foster circuit (-CNF) and the antenna (18) in a sensing circuit (10); and
tuning the tunable non-Foster circuit (-CNF) to minimize the combined reactance of the tunable non-Foster circuit (-CNF) and the antenna (18) as sensed by the sensing circuit (10);
and **characterized in that**
the tunable non-Foster circuit (-CNF) comprises an otherwise non-tunable non-Foster circuit (Cm, Q1, Q2) with a variable capacitance (Cvar) added across a negative impedance (-Cm) output of the otherwise non-tunable non-Foster circuit (Cm, Q1, Q2) to thereby render the otherwise non-tunable non-Foster circuit tunable;
wherein the variable capacitance (-Cm) is supplied by reverse biased varactor diodes (D1, D2) coupled in parallel with the negative impedance output of the otherwise non-tunable non-Foster circuit (Cm, Q1, Q2), a junction point between the series coupled varactor diodes providing a control input to the tunable non-Foster circuit.

7. A method of matching an antenna (18) to a radio receiver, the method comprising:

coupling a tunable non-Foster circuit (-CNF) between the receiver and the antenna (18), the receiver and the antenna (18) having a combined reactance;
sensing the combined reactance of the tunable non-Foster circuit (-CNF) and the antenna (18) in a sensing circuit (10); and
tuning the tunable non-Foster circuit (-CNF) to minimize the combined reactance of the tunable non-Foster circuit (-CNF) and the antenna (18) as sensed by the sensing circuit (10);
coupling a variable frequency oscillator (19) and the antenna (18) using said tunable non-Foster circuit (-CNF);
and **characterized in that**
the tunable non-Foster circuit (-CNF) comprises an otherwise non-tunable non-Foster circuit (Cm, Q1, Q2) with a variable reactance (Cvar) added across a negative impedance (-Cm) output of the otherwise non-tunable non-Foster circuit (Cm, Q1, Q2) to thereby render the otherwise non-tunable non-Foster circuit tunable; and wherein the variable reactance (Cvar) is supplied by reverse biased varactor diodes (D1, D2) coupled in parallel with the negative impedance (-Cm) output of the otherwise non-tunable non-Foster circuit (Cm, Q1, Q2), a junction point between the series coupled varactor diodes (D1, D2) providing a control input to the tunable non-Foster circuit.

**Patentansprüche**

1. Automatischer Abstimmkreis zur Anpassung einer Antenne (18) auf einen Funkempfänger, wobei der automatische Abstimmkreis folgendes umfasst:

   eine einstellbare Non-Foster-Schaltung (-CNF), die zur Kopplung mit dem Empfänger und der Antenne geeignet ist; und

   Mess- (10) und Rückkopplungs-Schaltungen (15), die sich zum Messen der kombinierten Reaktanz der einstellbaren Non-Foster-Schaltung (-CNF) und der Antenne (18) eignen, und die sich zur Einstellung der einstellbaren Non-Foster-Schaltung (-CNF), um die kombinierte Reaktanz der einstellbaren Non-Foster-Schaltung (-CNF) und der Antenne (18) automatisch zu minimieren;

   **dadurch gekennzeichnet, dass**

   die einstellbare Non-Foster-Schaltung (-CNF) eine ansonsten nicht einstellbare Non-Foster-Schaltung (Cm, Q1, Q2) mit einer variablen Kapazität (Cvar) umfasst, die über einen negativen Impedanz-Ausgang (-Cm) der ansonsten nicht einstellbaren Non-Foster-Schaltung (Cm, Q1, Q2) hinzugefügt wird, um die ansonsten nicht einstellbare Non-Foster-Schaltung einstellbar zu gestalten;

   wobei die variable Kapazität (-Cm) durch in Sperrrichtung vorgespannte Kapazitätsdioden (D1, D2) zugeführt wird, die parallel mit dem negativen Impedanz-Ausgang der ansonsten nicht einstellbaren Non-Foster-Schaltung (Cm, Q1, Q2) gekoppelt sind, wobei eine Verbindungsstelle zwischen den in Reihe gekoppelten Kapazitätsdioden einen Regelungseingang an die einstellbare Non-Foster-Schaltung bereitstellt.

2. Automatischer Abstimmkreis zur Anpassung einer Antenne (18) auf einen Funkempfänger, wobei der automatische Abstimmkreis folgendes umfasst:

   eine einstellbare Non-Foster-Schaltung (-CNF), die zur Kopplung mit dem Empfänger und der Antenne geeignet ist; und

   Mess- (10) und Rückkopplungs-Schaltungen (15), die sich zum Messen der kombinierten Reaktanz der einstellbaren Non-Foster-Schaltung (-CNF) und der Antenne (18) eignen, und die sich zur Einstellung der einstellbaren Non-Foster-Schaltung (-CNF), um die kombinierte Reaktanz der einstellbaren Non-Foster-Schaltung (-CNF) und der Antenne (18) automatisch zu minimieren;

   einen abstimmbaren Oszillator (19) und Mittel (SWITCH1) zur Kopplung des abstimmbaren Oszillators (19) und der Antenne (18) unter Verwendung der einstellbaren Non-Foster-Schaltung (-CNF);

   **dadurch gekennzeichnet, dass**

   die einstellbare Non-Foster-Schaltung (-CNF) eine ansonsten nicht einstellbare Non-Foster-Schaltung (Cm, Q1, Q2) mit einer variablen Reaktanz (Cvar) umfasst, die über einen negativen Impedanz-Ausgang (-Cm) der ansonsten nicht einstellbaren Non-Foster-Schaltung (Cm, Q1, Q2) hinzugefügt wird, um die ansonsten nicht einstellbare Non-Foster-Schaltung einstellbar zu gestalten; und

   wobei die variable Reaktanz (Cvar) durch in Sperrrichtung vorgespannte Kapazitätsdioden (D1, D2) zugeführt wird, die parallel mit dem negativen Impedanz-Ausgang (-Cm) der ansonsten nicht einstellbaren Non-Foster-Schaltung (Cm, Q1, Q2) gekoppelt sind, wobei eine Verbindungsstelle zwischen den in Reihe gekoppelten Kapazitätsdioden (D1, D2) einen Regelungseingang an die einstellbare Non-Foster-Schaltung bereitstellt.

3. Automatischer Abstimmkreis nach Anspruch 1 oder 2, wobei die Mess-(10) und Rückkopplungs-Schaltungen (15) folgendes umfassen:

   Mittel zum Messen (10) einer Eingangsimpedanz, die der Antenne (18) und der einstellbaren Non-Foster-Schaltung (-CNF) zugeordnet ist, wenn ein HF-Signal der Antenne (18) und der einstellbaren Non-Foster-Schaltung (-CNF) über das Mittel zum Messen (10) zugeführt wird; und

einen Operationsverstärker (14), dessen Ausgang mit dem Steuereingang der einstellbaren Non-Foster-Schaltung (-CNF) gekoppelt ist.

4. Automatischer Abstimmkreis nach Anspruch 3, wobei die Mess- (10) und Rückkopplungs-Schaltungen (15) ferner einen Abtast- und Haltekreis (16) umfassen, der zwischen den Operationsverstärker (14) und den der einstellbaren Non-Foster-Schaltung (-CNF) gekoppelt ist.

5. Automatischer Abstimmkreis nach Anspruch 1 oder 2, wobei die einstellbare Non-Foster-Schaltung (-CNF) einen variablen negativen Kondensator emuliert, und wobei die Antenne (18) eine Dipol- oder Monopolantenne ist.

6. Verfahren zur Anpassung einer Antenne (18) an einen Funkempfänger, wobei das Verfahren folgendes umfasst:

Koppeln einer einstellbaren Non-Foster-Schaltung (-CNF) zwischen dem Empfänger und der Antenne (18), wobei der Empfänger und die Antenne (18) eine kombinierte Reaktanz aufweisen;

Messen der kombinierten Reaktanz der einstellbaren Non-Foster-Schaltung (-CNF) und der Antenne (18) in einer Messschaltung (10); und

Einstellen der einstellbaren Non-Foster-Schaltung (-CNF), um die durch die Messschaltung (10) gemessene kombinierte Reaktanz der einstellbaren Non-Foster-Schaltung (-CNF) und der Antenne (18) zu minimieren; und **dadurch gekennzeichnet, dass**

die einstellbare Non-Foster-Schaltung (-CNF) eine ansonsten nicht einstellbare Non-Foster-Schaltung (Cm, Q1, Q2) mit einer variablen Kapazität (Cvar) umfasst, die über einen negativen Impedanz-Ausgang (-Cm) der ansonsten nicht einstellbaren Non-Foster-Schaltung (Cm, Q1, Q2) hinzugefügt wird, um die ansonsten nicht einstellbare Non-Foster-Schaltung einstellbar zu gestalten;

wobei die variable Kapazität (-Cm) durch in Sperrrichtung vorgespannte Kapazitätsdioden (D1, D2) zugeführt wird, die parallel mit dem negativen Impedanz-Ausgang der ansonsten nicht einstellbaren Non-Foster-Schaltung (Cm, Q1, Q2) gekoppelt sind, wobei eine Verbindungsstelle zwischen den in Reihe gekoppelten Kapazitätsdioden einen Regelungseingang an die einstellbare Non-Foster-Schaltung bereitstellt.

7. Verfahren zur Anpassung einer Antenne (18) an einen Funkempfänger, wobei das Verfahren folgendes umfasst:

Koppeln einer einstellbaren Non-Foster-Schaltung (-CNF) zwischen dem Empfänger und der Antenne (18), wobei der Empfänger und die Antenne (18) eine kombinierte Reaktanz aufweisen;

Messen der kombinierten Reaktanz der einstellbaren Non-Foster-Schaltung (-CNF) und der Antenne (18) in einer Messschaltung (10); und

Einstellen der einstellbaren Non-Foster-Schaltung (-CNF), um die durch die Messschaltung (10) gemessene kombinierte Reaktanz der einstellbaren Non-Foster-Schaltung (-CNF) und der Antenne (18) zu minimieren;

Koppeln eines abstimmbaren Oszillators (19) und der Antenne (18) unter Verwendung der einstellbaren Non-Foster-Schaltung (-CNF);

und **dadurch gekennzeichnet, dass**

die einstellbare Non-Foster-Schaltung (-CNF) eine ansonsten nicht einstellbare Non-Foster-Schaltung (Cm, Q1, Q2) mit einer variablen Reaktanz (Cvar) umfasst, die über einen negativen Impedanz-Ausgang (-Cm) der ansonsten nicht einstellbaren Non-Foster-Schaltung (Cm, Q1, Q2) hinzugefügt wird, um die ansonsten nicht einstellbare Non-Foster-Schaltung einstellbar zu gestalten; und

wobei die variable Reaktanz (Cvar) durch in Sperrrichtung vorgespannte Kapazitätsdioden (D1, D2) zugeführt wird, die parallel mit dem negativen Impedanz-Ausgang der ansonsten nicht einstellbaren Non-Foster-Schaltung (Cm, Q1, Q2) gekoppelt sind, wobei eine Verbindungsstelle zwischen den in Reihe gekoppelten Kapazitätsdioden einen Regelungseingang an die einstellbare Non-Foster-Schaltung bereitstellt.

## Revendications

1. Circuit d'accord automatique pour apparier une antenne (18) à un récepteur radio, le circuit d'accord automatique comprenant :

un circuit non-Foster accordable (-CNF) conçu pour le couplage du récepteur et de l'antenne ; et
des circuits de détection (10) et de rétroaction (15) conçus pour détecter la réactance combinée du circuit non-Foster accordable (-CNF) et de l'antenne (18) et conçus pour accorder le circuit non-Foster accordable (-CNF) afin de réduire à un minimum automatiquement la réactance combinée du circuit non-Foster accordable (-CNF) et de l'antenne (18) ;

**caractérisé en ce que**

le circuit non-Foster accordable (-CNF) comprend un circuit non-Foster autrement non accordable (Cm, Q1, Q2) avec une capacité variable (Cvar) ajoutée sur une sortie d'impédance négative (-Cm) du circuit non-Foster autrement non accordable (Cm, Q1, Q2) pour ainsi rendre accordable le circuit non-Foster autrement non accordable ;

la capacité variable (-Cm) étant fournie par des diodes varactors polarisées en inverse (D1, D2) couplées en parallèle avec la sortie d'impédance négative du circuit non-Foster autrement non accordable (Cm, Q1, Q2), un point de jonction entre les diodes varactors couplées en série fournissant une entrée de commande au circuit non-Foster accordable.

2. Circuit d'accord automatique pour apparier une antenne (18) à un récepteur radio, le circuit d'accord automatique comprenant :

un circuit non-Foster accordable (-CNF) conçu pour le couplage du récepteur et de l'antenne ; et
des circuits de détection (10) et de rétroaction (15) conçus pour détecter la réactance combinée du circuit non-Foster accordable (-CNF) et de l'antenne (18) et conçus pour accorder le circuit non-Foster accordable (-CNF) afin de réduire à un minimum automatiquement la réactance combinée du circuit non-Foster accordable (-CNF) et de l'antenne (18) ;
un oscillateur à fréquence variable (19), et un moyen (SWITCH1) pour coupler l'oscillateur à fréquence variable (19) et l'antenne (18) à l'aide dudit circuit non-Foster accordable (-CNF) ;

**caractérisé en ce que**

le circuit non-Foster accordable (-CNF) comprend un circuit non-Foster autrement non accordable (Cm, Q1, Q2) avec une réactance variable (Cvar) ajoutée à une sortie d'impédance négative (-Cm) du circuit non-Foster autrement non accordable (Cm, Q1, Q2) pour ainsi rendre accordable le circuit non-Foster autrement non accordable ; et

la réactance variable (-Cm) étant fournie par des diodes varactors polarisées en inverse (D1, D2) couplées en parallèle avec la sortie d'impédance négative (-Cm) du circuit non-Foster autrement non accordable (Cm, Q1, Q2), un point de jonction entre les diodes varactors (D1, D2) couplées en série fournissant une entrée de commande au circuit non-Foster accordable.

3. Circuit d'accord automatique selon la revendication 1 ou 2, les circuits de détection (10) et de rétroaction (15) comprenant :

un moyen de détection (10) d'une impédance d'entrée associée à l'antenne (18) et au circuit non-Foster accordable (-CNF) lorsqu'un signal RF est appliqué à l'antenne (18) et au circuit non-Foster accordable (-CNF) par l'intermédiaire du moyen de détection (10) ; et
un amplificateur opérationnel (14) dont la sortie est couplée à l'entrée de commande du circuit non-Foster accordable (-CNF).

4. Circuit d'accord automatique selon la revendication 3, les circuits de détection (10) et de rétroaction (15) comprenant en outre un circuit d'échantillonnage et de maintien (16) couplé entre ledit amplificateur opérationnel (14) et ladite entrée de commande du circuit non-Foster accordable (-CNF).

5. Circuit d'accord automatique selon la revendication 1 ou 2, le circuit accordable non-Foster (-CNF) émulant un condensateur négatif variable et l'antenne (18) étant un dipôle ou un monopôle.

6. Procédé d'appariement d'une antenne (18) à un récepteur radio, le procédé comprenant les étapes consistant à :

coupler un circuit non-Foster accordable (-CNF) entre le récepteur et l'antenne (18), le récepteur et l'antenne (18) ayant une réactance combinée ;
détecter la réactance combinée du circuit accordable non-Foster (-CNF) et de l'antenne (18) dans un circuit de détection (10) ; et
accorder le circuit non-Foster accordable (-CNF) pour réduire à un minimum la réactance combinée du circuit non-Foster accordable (-CNF) et de l'antenne (18) telle que détectée par le circuit de détection (10) ;
et **caractérisé en ce que**

le circuit non-Foster accordable (-CNF) comprend un circuit non-Foster autrement non accordable (Cm, Q1, Q2) avec une capacité variable (Cvar) ajoutée sur une sortie d'impédance négative (-Cm) du circuit non-Foster autrement non accordable (Cm, Q1, Q2) pour ainsi rendre accordable le circuit non-Foster autrement non accordable ;

la capacité variable (-Cm) étant fournie par des diodes varactors polarisées en inverse (D1, D2) couplées en parallèle avec la sortie d'impédance négative du circuit non-Foster autrement non accordable (Cm, Q1, Q2), un point de jonction entre les diodes varactors couplées en série fournissant une entrée de commande au circuit non-Foster accordable.

7. Procédé d'appariement d'une antenne (18) à un récepteur radio, le procédé comprenant les étapes consistant à :

coupler un circuit non-Foster accordable (-CNF) entre le récepteur et l'antenne (18), le récepteur et l'antenne (18) ayant une réactance combinée ;

détecter la réactance combinée du circuit accordable non-Foster (-CNF) et de l'antenne (18) dans un circuit de détection (10) ; et

accorder le circuit non-Foster accordable (-CNF) pour réduire à un minimum la réactance combinée du circuit non-Foster accordable (-CNF) et de l'antenne (18) telle que détectée par le circuit de détection (10) ;

coupler un oscillateur à fréquence variable (19) et l'antenne (18) à l'aide dudit circuit non-Foster accordable (-CNF) ;

et **caractérisé en ce que**

le circuit non-Foster accordable (-CNF) comprend un circuit non-Foster autrement non accordable (Cm, Q1, Q2) avec une réactance variable (Cvar) ajoutée à une sortie d'impédance négative (-Cm) du circuit non-Foster autrement non accordable (Cm, Q1, Q2) pour ainsi rendre accordable le circuit non-Foster autrement non accordable ; et

la réactance variable (-Cm) étant fournie par des diodes varactors polarisés en inverse (D1, D2) couplées en parallèle avec la sortie d'impédance négative (-Cm) du circuit non-Foster autrement non accordable (Cm, Q1, Q2), un point de jonction entre les diodes varactors (D1, D2) couplées en série fournissant une entrée de commande au circuit non-Foster accordable.

**FIG. 1**

**FIG. 2**

**FIG. 3**

FIG. 4

**FIG. 5**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4234960 A

- EP 2290745 A1

**Non-patent literature cited in the description**

- The End of Spectrum Scarcity. IEEE Spectrum

- **A. V. BEZOOIJEN et al.** RF-MEMS based adaptive antenna matching module. *IEEE RFIC Symposium,* 2007